Europäisches Patentamt

European Patent Office

Office européen des brevets

(11) Publication number: **0 142 907 B1**

# EUROPEAN PATENT SPECIFICATION

(45) Date of publication of patent specification: **17.03.93**   (51) Int. Cl.⁵: **H03M 1/20**, H03M 1/66

(21) Application number: **84305049.3**

(22) Date of filing: **25.07.84**

Divisional application 91200653.3 filed on 25/07/84.

(54) **Apparatus and methods for analogue-to-digital and digital-to-analogue conversion.**

(30) Priority: **29.07.83 GB 8320534**

(43) Date of publication of application:
**29.05.85 Bulletin 85/22**

(45) Publication of the grant of the patent:
**17.03.93 Bulletin 93/11**

(84) Designated Contracting States:
**DE FR GB**

(56) References cited:
**DE-A- 3 212 103       FR-A- 2 232 881
GB-A- 1 444 216       US-A- 2 625 604
US-A- 3 877 022       US-A- 3 987 436
US-A- 4 006 475**

(73) Proprietor: **Burr-Brown Corporation
6730 S. Tucson Blvd.
Tucson Arizona 85706(US)**

(72) Inventor: **Belcher, Raymond Allan
75 Pastoral Way
Sketty Swansea SA2 9LY(GB)**

(74) Representative: **Boon, Graham Anthony et al
Elkington and Fife Prospect House 8 Pembroke Road
Sevenoaks, Kent TN13 1XR (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to apparatus and methods for analogue-to-digital (A-to-D) and digital-to-analogue (D-to-A) conversion.

The quantising accuracy of A-to-D and D-to-A converters is, in general, limited by the accuracy to which electronic components can be manufactured or the speed at which electronic switches can operate. The term converter is used in this specification when a reference is made to either type of converter.

A speed times accuracy product can be found which applies to each method of conversion and provides a performance indicator. This indicator is of most importance in monolithic circuit versions of converters. For example, one method such as the 'flash' technique of analogue-to-digital conversion can produce a quantised output in a very short time and is probably the fastest conversion method. The quantising accuracy is at the moment, however, limited to at most 8 binary digits (bits) because a potential divider is required to generate reference voltages for the $(2^8 - 1)$ comparators required, and with present integrated circuit technology the potential divider cannot be manufactured easily with an accuracy or stability greater than that needed for 8 bit conversion. Techniques such as laser trimming or 'zener zapping' can be used to trim the potential divider to greater accuracy, and this could extend the quantising accuracy to 12 bits, though at increased production cost.

The limiting factor with integrated circuit 'flash' converters is the number of comparators which can be accommodated in a high-speed integrated circuit within an economic die size, and this limits the quantising accuracy to about 10 bits at present. The maximum sampling frequency of a 'flash' 10 bit converter is in the region of 20 MHz, whereas the sampling frequency of a 1 bit converter can be as much as 500 MHz. Converters with a quantising accuracy of 16 bits are at present limited to sampling frequencies in the region of 50 kHz.

This higher accuracy can be obtained by using inherently slow-speed conversion techniques (e.g. the dual-slope ramp-converter) which do not depend on high accuracy resistor networks.

The practical constraints of integrated circuit technology therefore enable low quantising distortion (up to 16 bits) to be achieved but at a low sampling frequency. Alternatively, a very high sampling frequency can be obtained if high quantising distortion (1 bit) is acceptable.

Oversampling is a well-known technique for trading speed for accuracy, in which sampling is carried out at a frequency which is higher than the Nyquist frequency.

The r.m.s. sinewave signal to r.m.s. quantising noise ratio in a bandwidth $f_B$ produced by an n bit A-to-D converter at a sampling rate of $2f_B$ is equal to $(6n + 1.8)$dB. If the sampling frequency is greater than the Nyquist $(2f_B)$ frequency, then the noise within the baseband up to $f_B$ is reduced. Every time the sampling frequency is doubled the quantising noise power in the baseband up to $f_B$ is reduced by 3dB. It can be seen that a fourfold increase in sampling frequency is necessary to reduce the baseband noise by 6dB: equivalent to that given by an analogue-to-digital converter of 1 bit greater accuracy, sampled at the Nyquist rate.

Another problem which occurs in A-to-D and D-to-A converters is that of providing equally spaced quantising levels. Due to component tolerances such converters usually have some degree of non-uniformity in this respect.

Figure 1 of DE-A-3212103 shows a sample and hold circuit sampled at a first frequency in producing a signal that is combined with an interpolation signal sample at a second frequency to produce a combined input applied to the input of an analog-to-digital converter, the output of which is time-averaged to produce a digital output with a higher number of bits than the analog-to-digital converter i.e., with increased resolution, but without increase in accuracy or linearity. The disclosure of FR-A-2232881 is similar to that of DE-A-3212103 except that the sample and hold technique is not provided. In both these documents the amplitude of the interpolating signal is disclosed to be a small value, less than or equal to one LSB.

US-A-4,006,475 discloses high speed accumulation in which a least significant bit group of the input word is recurrently accumulated, and an overflow carry is added to the most significant bit group of the same input word. The resulting sum is sampled at the rate of the least significant bit group accumulations to produce a digital signal which is converted to analog form by a resistor network, which functions as a digital-to-analog converter, the analog output of which is time-averaged by a filter.

According to a first aspect of the present invention there is provided an n + m bit analog-to-digital converter circuit including

an analog input and n + m output bits, n and m being integers,

a sample and hold circuit having an input terminal receiving an analog input signal, a control input terminal, an output terminal, and means for applying a first sampling signal having a first frequency to the control input terminal to cause the sample and hold circuit to produce a sampled analog signal on the output terminal,

an interpolation signal generating circuit producing a periodic interpolation signal having a second frequency,

a combining circuit combining the interpolation signal and the sampled analog signal to produce a combined signal,

an n-bit analog-to-digital converter receiving the combined signal and converting it to n-bit digital numbers in response to a conversion control signal of the second frequency,

digital time averaging circuit means for accumulating the n-bit digital numbers produced during each period of the first frequency and averaging the accumulated total thereof over that period,

characterized by:

the n-bit analog-to-digital converter having accuracy less than $m + n$ bit accuracy, the second frequency is $2^m$ times the first frequency, the combined signal having $2^m$ steps in each period of the sampling signal, and the analog-to-digital converter having a quantizing interval [d1] which is no more than

$$\left[ \frac{p}{2} \left( 1 - \frac{2p - \log_2 p}{2p + 1} \right) \right]^{-1}$$

times the magnitude of the change effected by the combining circuit on the sampled analog signal in one period of the interpolation signal, wherein $p = 2^m$, and wherein the maximum excursion of the interpolation signal is at least as great as the quantizing interval;

the digital time-averaging circuit means producing the averaged accumulated total as $n + m$ bit digital numbers;

an $n + m$ bit latching circuit for receiving and latching the $n + m$ bit digital numbers, and

means for sampling the $n + m$ bit latching circuit at a rate equal to the first frequency to produce $n + m$ bit digital numbers accurately representative of the analog input signal.

According to another aspect of the present invention there is provided an $n + m$ bit analog-to-digital converter circuit including

an analog input and $n + m$ output bits, n and m being integers,

a sample and hold circuit having an input terminal receiving an analog input signal, a control input terminal, an output terminal, and means for applying a first sampling signal having a first frequency to the control input terminal to cause the sample and hold circuit to produce a sampled analog signal on the output terminal,

an interpolation signal generating circuit producing a periodic interpolation signal having a second frequency,

a combining circuit combining the interpolation signal and the sampled analog signal to produce a combined signal,

an n-bit analog-to-digital converter receiving the combined signal and converting it to n-bit digital numbers in response to a conversion control signal of the second frequency,

digital time averaging circuit means for accumulating the n-bit digital numbers produced during each period of the first frequency and averaging the accumulated total thereof over that period,

characterised by:

the n-bit analog-to-digital converter having accuracy less than $m + n$ accuracy, the second frequency is $2^m$ times the first frequency, the combined signal having $2^m$ steps in each period of the sampling signal, and the analog-to-digital converter having a quantizing interval which is no more than

$$\left[ \frac{p}{2} \left( 1 - \frac{2p - \log_2 p}{2p + 1} \right) \right]^{-1}$$

times the magnitude of the change effected by the combining circuit on the sampled analog signal in one period of the interpolation signal, wherein $p = 2^m$;

the digital time-averaging circuit means producing the averaged accumulated total as $n + m$ bit digital numbers;

an $n + m$ bit latching circuit for receiving and latching the $n + m$ bit digital numbers, and

means for sampling the n + m bit latching circuit at a rate equal to the first frequency to produce n + m bit digital numbers accurately representative of the analog input signal wherein the interpolation signal has a stepped waveform and a repetition frequency equal to the first frequency, and the interpolation signal has a maximum excursion of at least

$$\frac{2^m - 1}{2^m}$$

times the quantizing interval, each step having a duration equal to the period of the second frequency and a magnitude equal to the magnitude of the interpolation signal divided by the number of step transitions in each period of the first frequency.

According to yet another aspect of the present invention there is provided a method of converting an analog signal to a digital number, the method including:

sampling a level of the analog signal at a first frequency and holding each sampled level until a next sampled level is obtained,

combining each sampled and held level with an interpolation signal having a second frequency to produce a combined signal,

operating an n-bit analog-to-digital converter to convert each level of the combined signal to digital numbers, and

averaging the digital numbers,

characterized by:

the second frequency being $2^m$ times the first frequency so that the combined signal has $2^m$ steps during each period of the first frequency, m being an integer,

the analog-to-digital converter having a quantizing interval [d1] which is no more than

$$\left[ \frac{p}{2} \left( 1 - \frac{2p - \log_2 p}{2p + 1} \right) \right]^{-1}$$

times the magnitude of the change effected in one period of the interpolation signal by combining the interpolation signal with the sampled level held, wherein $p = 2^m$, and wherein the maximum excursion of the interpolation signal is at least as great as the quantizing interval,

operating the n-bit analog-to-digital converter to convert the level of each of the $2^m$ steps to $2^{m+n}$ bit digital numbers,

time-averaging the $2^{m+n}$ bit digital numbers in each period of the first frequency to produce an n + m bit digital number for each period of the first frequency,

storing each of the n + m bit digital numbers in a latch and sampling the stored n + m bit digital numbers at a rate equal to the first frequency to produce n + m bit digital numbers which accurately represent the analog input signal, and

repeating the foregoing steps for successive periods of the first frequency.

According to a further aspect of the present invention there is provided a digital-to-analog conversion device including:

means for holding successive values of an n-bit digital signal to be converted one at a time, successive values of the n-bit digital signal being substituted at a first frequency,

means for combining an output signal of the holding means with an interpolation signal that is periodic at a second frequency,

a digital-to-analog converter,

means for averaging the analog output signal,

characterized by:

the second frequency being $2^m$ times the first frequency, m being a positive integer;

the combining means including an n-bit counter for producing an n-m bit output signal, means for setting the counter to the current value of the n-bit digital signal at the first frequency and means for incrementing or decrementing the counter at the second frequency during each period of the first frequency so that there are $2^m$ times more values of the n-m bit output signal than of the n-bit digital signal, wherein the holding means and

4

the combining means together comprise the counter, the means for setting the counter at the first frequency, and the means for incrementing or decrementing the counter at the second frequency during each period of the first frequency, the counter produces a carry signal;

logic gating means for coupling bit levels of the n-m bit output signal to n-m bit input terminals, respectively, of the n-m bit digital-to-analog converter, the logic gating means including n-m OR gates each having an input terminal receiving the carry signal and an input terminal receiving a respective bit level of the n-m bit output signal;

the digital-to-analog converter being an n-m bit digital-to-analog converter coupled to the n-m bit output signal and operating in response to a control signal that is periodic at the second frequency to convert each of the values of the n-m bit output signal to a corresponding analog value to produce an analog output signal having $2^m$ analog values for each value of the n-bit digital signal, the digital-to-analog converter having a quantizing interval which is no more than

$$\left[ \frac{p}{2} \left( 1 - \frac{2p - \log_2 p}{2p + 1} \right) \right]^{-1}$$

times the magnitude of the change effected in one period of the interpolation signal by combining the interpolation signal with the sampled signal held, wherein $p = 2^m$, and wherein the maximum excursion of the interpolation signal is at least as great as the quantizing interval; and

the analog output signal having a bandwidth $f_B$, and the first frequency is at least $2f_B$.

According to a still further aspect of the present invention there is provided a method of converting a plurality of digital signals to an analog signal including holding values of an n-bit digital signal to be converted one at a time and sampling successive values of the n-bit digital signal at a first frequency, combining the sampled signal with an interpolation signal that is periodic at a second frequency, converting bit levels of the resulting combined signals to inputs of a digital-to-analog converter, and averaging the analog output signal produced by the digital-to-analog converter,

characterized by:

combining the held signals with the interpolation signal by means of a n-bit counter by setting the n-bit counter to current values of the n-bit digital signal at the first frequency, and incrementing or decrementing the n-bit counter at the second frequency during each period of the first frequency,

the second frequency being $2^m$ times the first frequency to produce an n-m bit output signal, m being a positive integer; and

coupling bit levels of the n-m bit output signal to n-m input terminals, respectively, of an n-m bit digital-to-analog converter, passing the n-m most significant bits of the counter to n-m input terminals, respectively, of the n-m bit digital-to-analog converter by means of n-m OR gates, one input terminal of each of the OR gates being connected to a carry output terminal of the n-bit counter, the digital-to-analog converter having a quantizing interval which is no more than

$$\left[ \frac{p}{2} \left( 1 - \frac{2p - \log_2 p}{2p + 1} \right) \right]^{-1}$$

times the magnitude of the change effected in one period of the interpolation signal by combining the interpolation signal with the sampled signal held, wherein $p = 2^m$, wherein the maximum excursion of the interpolation signal is at least as great as the quantizing interval.

The combining means may comprise addition means for adding the interpolation signal to the output signal of the holding means, the interpolation signal having a maximum excursion which is at least

$$\frac{p}{2} \left( 1 - \frac{2p - \log_2 p}{2p + 1} \right)$$

times the interval $d_1$. Since subtraction is the addition of a negative number, the word 'addition' as used in the claims of this specification includes subtraction. Alternatively, the combining means may comprise means for multiplying or dividing the output signal of the holding means by a multiplier or divisor which varies periodically at the first frequency or a multiple thereof to provide the required change in magnitude.

An important advantage of the present invention as applied to binary A-to-D converters is that where the converter used has an accuracy when sampling at the second frequency of, for example, n bits, the accuracy of the output obtained from the apparatus according to the invention is $(m + n)$ bits where p equals $2^m$. In D-to-A conversion if the converter has an accuracy of $(n - m)$ bits when operating at the second frequency there are more steps in its output signal per unit time than would be available by using an n bit converter at a necessarily slower rate. A "smoother" output analog signal can be obtained by averaging a converter output if the converter output has more output steps per unit time.

For optimum increase in signal to quantising noise ratio the said maximum excursion should be less than the quantising interval of the converter. However, the above-mentioned problem of non-uniformity in quantising levels can be lessened by employing a maximum excursion which spans several quantising intervals. Such improvement is at the expense of the speed times accuracy product since as the signal at the first frequency has a greater excursion, more time is required to cover this excursion and convert the signal so provided to a digital or an analog output.

At the expense of the speed times accuracy product, the signal which is added by the addition means may be periodic at a multiple of the first frequency.

In the A-to-D converter circuit the combining means may add a sawtooth waveform having a repetition frequency equal to the first frequency and the combining means then includes a further sample-and-hold circuit operating at the second frequency for generating samples of the signals formed by addition for application to the converter. Alternatively the combining means may add a stepped waveform, having a repetition frequency equal to the first frequency and steps of duration equal to the period of the second frequency. Each step may have a magnitude equal to the said maximum excursion of the periodic signal divided by the number of step transitions. The averaging means may comprise an accumulator circuit arranged to be reset at the first frequency.

In D-to-A conversion the said quantising interval is the difference between the magnitudes of adjacent levels in the analog output before significant smoothing takes place.

In the D-to-A conversion device the holding means and the addition means together may comprise an up/down counter which is arranged both to be reset at the first frequency to values of the input for conversion and to be incremented or decremented at the second frequency in each period of the first frequency.

The D-to-A conversion device may be capable of converting binary signals having q bits where q is less than the number of bits in the output of the up/down counter, only the q most significant bits being passed from the counter to the converter. The averaging means may be a low pass filter having a cut-off frequency at the top of the desired bandwidth for output signals.

Certain embodiments of the invention will now be described by way of example with reference to the accompanying drawings in which:

Figure 1 is a block diagram of A-to-D conversion apparatus according to an embodiment of the invention,

Figure 2 shows an interpolation waveform for use in A-to-D conversion,

Figure 3 is a diagram illustrating the way in which averaging takes place in the circuit of Figure 1,

Figure 4 is a block diagram of a D-to-A conversion apparatus according to an embodiment of the invention,

Figure 5 is a diagram illustrating the effect of incrementing the up/down converter of Figure 4,

Figure 6 is a block diagram of a circuit which may be used as an alternative to part of Figure 1,

Figure 7 is a block diagram of a processor which may be used as an alternative to part of Figure 1,

Figure 8 is a block diagram of an alternative processor to that of Figure 7, and

Figures 9 to 12 illustrate interpolation waveforms.

Figures 13 and 15 are block diagrams of modified arrangements, and

Figure 14 shows interpolation waveforms using the arrangements of Figures 13 and 15.

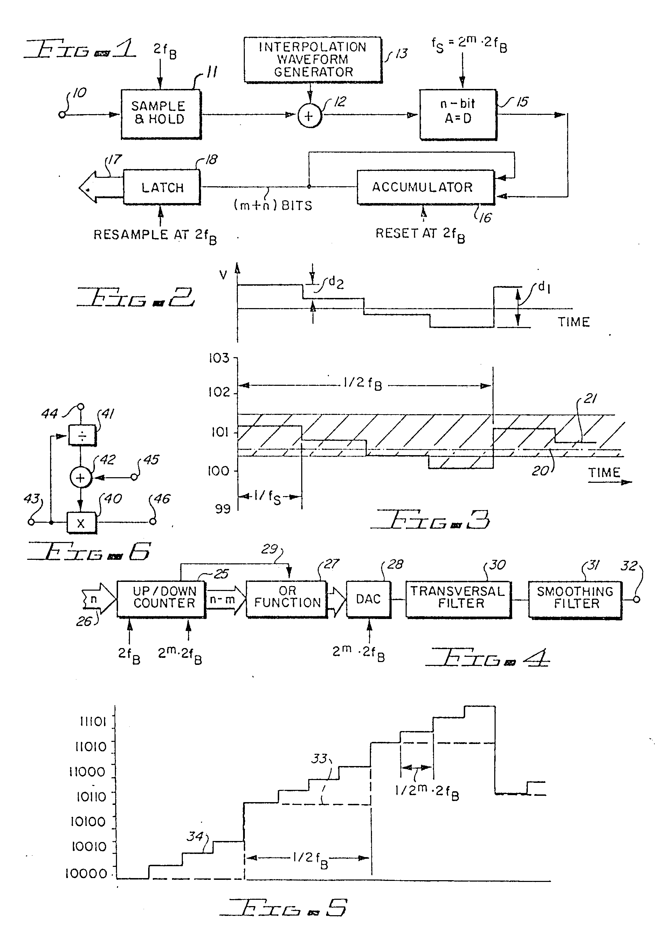

In the A-to-D converter apparatus of Figure 1 an input waveform to be digitised is applied to a terminal 10 and thence to a sample-and-hold circuit 11 sampling at a frequency $2f_B$ where $f_B$ is the input bandwidth of the incoming signal. By means of an addition circuit 12 a signal from an interpolation waveform generator 13 is added to the output of the sample-and-hold circuit 11.

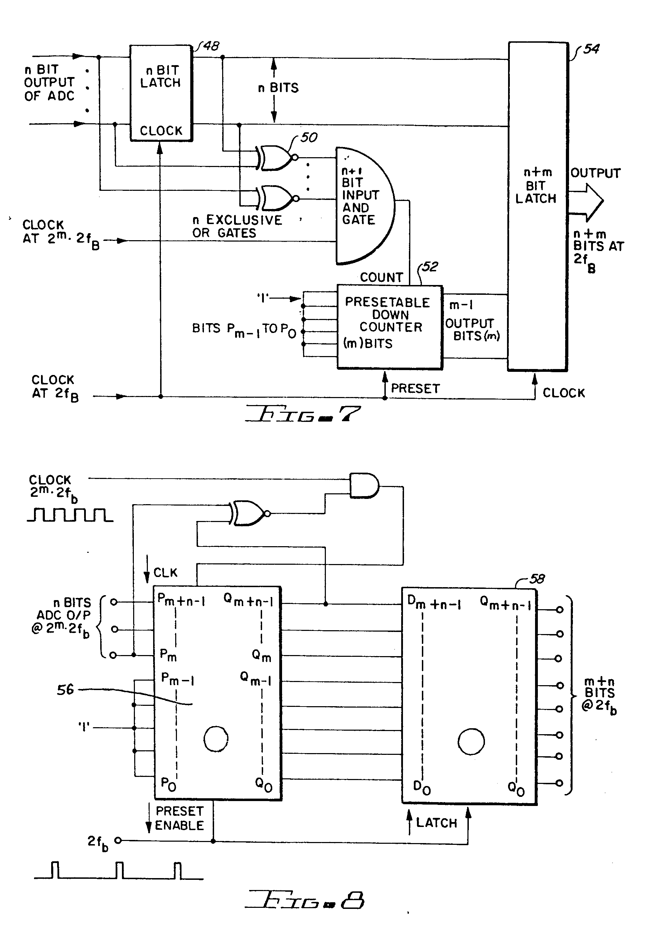

One form of interpolation waveform is shown in Figure 2. It has a period of $1/2f_B$ and decreases in steps $d_2$ at the ends of periods $l/f_S$. The frequency $f_S$ is the frequency of conversion in a A-to-D converter 15, and flyback to the initial magnitude of the interpolation waveform occurs at the end of each period $l/f_S$. The

frequency $f_S = 2^m.2f_B$ and therefore there are $2^m - 1$ step transitions in the interpolation waveform excluding flyback.

For binary conversion, the maximum excursion of the interpolation waveform should, at least, equal a magnitude $d_1.(2^m -1)/2^m$ where $d_1$ is the quantising interval of the converter 15 and has a value which is no more than:

$$\left[ \frac{p}{2} \left( 1 - \frac{2p - \log_2 p)}{2p+1} \right) \right]^{-1}$$

times the magnitude of the change effected by the addition circuit 12 on the output signal of the sample-and-hold circuit 11 in one period of the interpolation signal, wherein $p = 2^m$. In the example shown the maximum excursion is equal to $d_1$, and $d_2 = d_1/3$ since there are three step transitions in each cycle of the interpolation waveform (again excluding flyback).

The output of the A-to-D converter 15 contains $2^m$ samples for each sample at the output of the circuit 11 and this increased number of samples is averaged by means of a resettable accumulator 16 which is reset at intervals of $1/2f_B$. As a result the output of the accumulator 16 contains $m + n$ bits. The accumulator adds together the values presented at its two inputs to produce a running sum. Each new input is added to the previous sum provided by way of the feedback path shown.

In order to give an $(m + n)$ bit pcm parallel output while the accumulator 16 is operating, it is connected to a parallel output channel 17 by way of an output latch circuit 18 sampled at $2f_B$. The latch circuit holds the result produced by the accumulator 16 over a period $1/2f_B$ when the accumulator is reset and a new value is derived.

Another interpolation waveform which may be used is a sawtooth waveform having a maximum excursion of $d_1$ and an average d.c. value of zero. A further sample-and-hold circuit (not shown), sampling at $2^m.2f_B$, is then connected between the addition circuit 12 and the converter 15. In view of the use of the further sample-and-hold circuit the maximum excursion $d_1$ cannot be reduced to

$$\frac{2^m - 1}{2^m} . d_1$$

as for the stepped interpolation waveform. Either of the two previously mentioned waveforms may be used when modified to have a d.c. value equal to $\pm d_1/2$, and either may increase progressively with time, rather than decreasing.

A triangle waveform is another suitable interpolation waveform.

An input low-pass anti-aliasing filter (not shown) of bandwidth $f_B$ is connected at the input terminal 10 since a filter of this type is a requirement of all sampled systems.

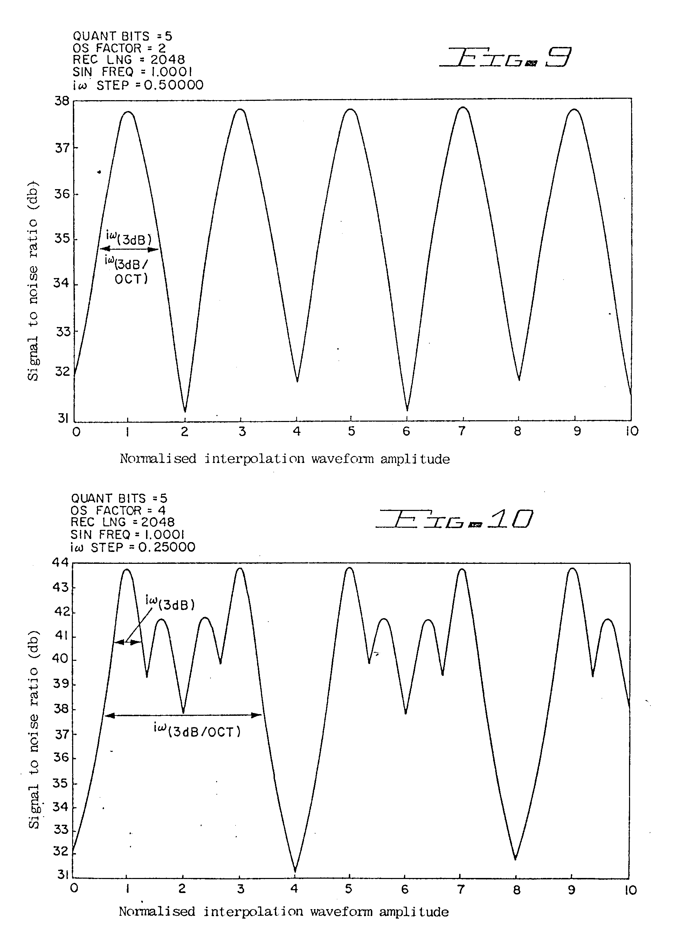

An example of the operation of the apparatus of Figure 1 is now given. In Figure 3 one output level from the sample-and-hold circuit 11 over the period $1/2f_B$ is shown by a chain dotted line 20. The vertical axis is divided according to decimal code corresponding to magnitude of input level to the converter 15. Only a portion of the axis is shown over the interval 99 to 103. In a conventional A-to-D converter the output code corresponding to a given magnitude is given for any input amplitude within $\pm\frac{1}{2}$ a quantising interval of that magnitude; for example, any magnitude in the interval 100.5 to 101.5, that is within the shaded area of Figure 3, receives the output code 101. Thus the level 20 corresponds to an output level 101 from the converter 15 but in fact the level could be said to be 100.67 (say). When the interpolation waveform is added the resultant is as shown by the continuous line 21 and the samples obtained at the rate $f_S$ are 101, 101, 101, 100 and when these samples are averaged by the accumulator 16 the result 100.75 is provided and an increase in accuracy of 2 bits is obtained. In this example since there are (4-1) steps in the quantising signal $2^m = 4$ and $m = 2$.

As has already been mentioned at present 16 bit converters operating at 50 KHz and 10 bit converters operating at 20 MHz are, for example, obtainable. If $2f_B$ is 50 KHz then a 16 bit output can be obtained without using the invention or oversampling using the first of these converters. By oversampling at 200 KHz (not using the invention) a 1 bit increase in accuracy to 17 bits could be obtained if this were possible. On the other hand by using the invention with the converter which samples at 20 MHz, m is between $2^8$ and $2^9$

and therefore the accuracy is n + m = 18 or 19 bits,

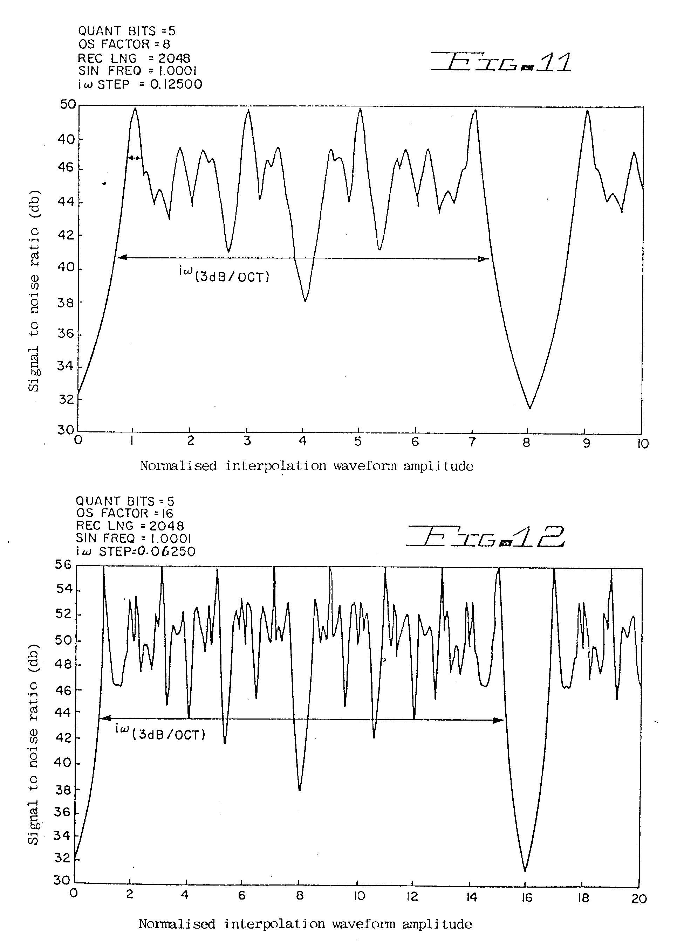

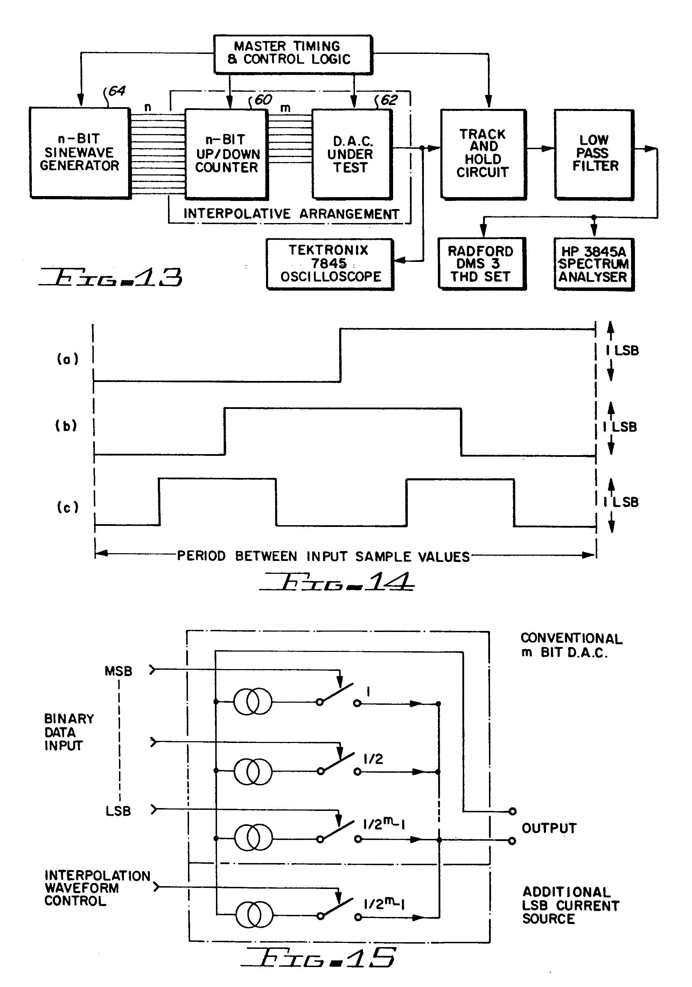

An alternative way of combining the output of the sample-and-hold circuit 11 with the output of the generator 13 is to replace the addition circuit 12 of Figure 1 with the circuit of Figure 6 which employs a multiplier circuit 40, a divider circuit 41 and an addition circuit 42. The output $V_w$ of the sample-and-hold circuit 11 and the output $V_i$ of the interpolation waveform generator 13 are applied to terminals 43 and 44, respectively. The divider circuit 41 provides an output $V_i/V_w$ to which one is added by the circuit 42 which has unity input at a terminal 45. On multiplication by $V_w$ in the multiplier 40, the output $(V_i/V_w + 1)$ of the circuit 42 is converted to $V_i + V_w$ and appears at a terminal 46 for application to the A-D converter 15.

The divider circuit 41 may be formed, according to a known technique, by a multiplier using a negative feedback loop.

The D-to-A converter of Figure 4 is now described. An up/down counter 25 receives an n bit pcm signal at a sample rate $2f_B$ by way of a parallel input channel 26. The up/down counter is set at intervals $1/2f_B$ to the current value of the n bit pcm and it is counted up by one bit at a frequency of $2^m.2f_B$ so that there are $2^m$ times more samples in a given time at the output of the counter 25 than at its input.

These samples are passed to an OR function circuit 27 at the rate $2^m.2f_B$ but only the n-m most significant bits are passed to the OR function circuit. The circuit 27 ensures that the reduced number of bits does not result in all zeros being passed on to a D-to-A converter 28 when as a result of counting up the counter 25 resets with all zeros. For this purpose the "carry" output of the counter 25 is connected to an input of the OR function circuit 27. The circuit 27 comprises (n-m) OR gates each receiving one input from the counter 25 and another input from the carry output from the counter 25.

The D-to-A converter 28 operates at the frequency $2^m.2f_B$ and therefore has an output level rate $2^m$ times greater than would be obtained by applying the input at the channel 26 to a D-to-A converter operating at $2f_B$. The converter 28 has a quantising interval $d_1$ which is no more than:

$$\left[ \frac{p}{2} \left( 1 - \frac{2p - \log_2 p}{2p + 1} \right) \right]^{-1}$$

times the magnitude of the change effected in one period of the interpolation signal by counter 25 in combining the interpolation signal with the sample signal held, where $p = 2^m$. The output from the converter 28 is applied to a transversal filter 30 which carries out signal averaging which is equivalent to that of the accumulator of Figure 1. The transversal filter may have $2^m-1$ sections in series each imparting a delay of

$$\frac{1}{2^m.2f_B},$$

with the circuit input signal, and the outputs of each section taken to common summing circuit whose output is sampled at $2f_B$. The tap coefficient for each summing circuit input is unity. The output of such a filter, when used in the circuit of Figure 4, is the same as that produced by an ideal n-bit D-to-A converter. A smoothing filter 31 is connected at the output of the filter 30 to complete the process of removing quantisation noise contained in the band above the frequency $f_B$. Alternatively, a single low-pass filter with a high degree of attenuation above the frequency $f_B$ can be used to smooth the output of the D-to-A converter 28.

An example of the operation of Figure 4 will now be given. Suppose three samples of a 5-bit input signal are applied to channel 26 and the three samples have values 10000, 10110 and 11001 as shown in Figure 5 by the dashed line 33. The states taken up by the counter 25 are then as shown by the solid line 34 so that after truncation to provide an (n-m) input for the converter 28 the following samples are provided in the interval in which the three original samples occurred:-

100, 100, 100, 100, 101, 101, 110, 110, 110, 110, 110 and 111.

These signals are applied to the converter 28 and the resulting output signal has more changes per unit time than the original signal. A relatively smooth analogue output is therefore obtained from the filter 31. The outputs of the converter 28 are summed in groups of four ($2^m$) by the transversal filter 30 to give 10000, 10110 and 11001 for the samples mentioned above, and these are the values which a 5-bit converter would have provided.

To contrast the invention with the prior art, if a 16 bit D-to-A converter is available, then without using the invention one of $2^{16}$ output levels could be obtained at a rate of 50 KHz for smoothing. However, if a 10 bit converter which operates at 20 MHz is used according to the invention, n = m = 10 and m is between 8 and 9. Thus $2^{10}$ possible output levels at a rate of 20 MHz are provided and after smoothing between $2^{18}$ and $2^{19}$ possible output levels are obtained at a rate of 50 KHz.

The up/down converter 25 may be connected to count down during each period of $1/2f_B$, but a d.c. offset then occurs in the output signal. This is unimportant for conversion of audio signals and can be removed, if required, by the use of a coupling capacitor.

Two features of the A-to-D converter (ADC) output used as part of the proposed interpolative encoding system enable a logical processing stage to replace the digital accumulator 16 to obtain higher resolution PCM output words.

These features are the monotonic and bivalued nature of the output stream.

Consider an n bit ADC oversampled at M times

$$N = 2^n$$
$$M = 2^m$$

for every input sampled, the ADC produces an output stream X

$$X = \left[ x(n) \right] \qquad \begin{aligned} n &= 1, \ldots, M \\ x &= 0, \ldots, N-1, \end{aligned} \qquad (1)$$

Because of the type of interpolation waveform used (: linear staircase of amplitude less than 1 ℓ.s.b.) there is provided

$$x(n) = \begin{cases} k & n = 1, \ldots, \ell \\ k+1 & n = \ell + 1, \ldots, M \end{cases} \qquad (2)$$

Therefore, in general, the ADC output stream during each sampling period consists of two values: a set of ℓ values, k, followed by a set of M - ℓ values, K + 1,.

$$\text{e.g. } n = 2 \quad M = 4 \qquad \begin{array}{c} x(4)\,x(3)\,x(2)\,x(1) \\ 3\,3\,3\,2 \\ 2\,2\,1\,1 \\ 1\,0\,0\,0 \end{array}$$

The function of the accumulator 16 is to add this stream

$$A = \sum_{n=1}^{M} x(n) \qquad (3)$$

9

$$= \sum_{n=1}^{\ell} k + \sum_{n=\ell+1}^{M} k + 1$$

$$= \ell k + (M-\ell)(k+1).$$

$$A = Mk + (M - \ell) \qquad\qquad (4)$$

$$k = x(1) \qquad\qquad \text{from (2)}$$

so computing the sum is equivalent to multiplying the first value in the stream by M. This can be achieved by shifting the binary value of k by m bits to the left. The binary k constitutes the n most significant bits of the output.

The remainder M-$\ell$ consists the m least significant bits. This can be computed by latching the first input of any stream and comparing it with subsequent values to obtain $\ell$. M-$\ell$ can be computed by decrementing a counter presetted to M.

A circuit for the implementation of this idea is illustrated in Figure 7. An alternative arrangement which can be implemented using a smaller number of available integrated circuits is depicted in Figure 8. The arrangement of Figure 7 requires less gates and would therefore be of interest when the arrangement is manufactured as a single integrated circuit, as it would require less silicon area than the arrangement of Figure 8.

This system avoids the use of adders. An implicit multiplication is performed (4), and can be implemented at higher speeds than the accumulator 16. This is because features of the ADC output stream are utilized to enable simpler, and hence faster, logic circuitry to be employed.

The limitation of this approach is in that it assumes the ADC is being used with an interpolation waveform amplitude of less than 1 $\ell$.s.b., i.e. the threshold positions of the ADC are near-ideal. If an ADC with significant threshold errors is used, then it would be normal to use an interpolation waveform amplitude of more than 1 $\ell$.s.b. The system described here could be extended using more complex logic circuitry to cope with this situation, but at the expense of speed of operation. The optimum choice between this approach and the use of a resettable accumulator 16 is one involving engineering judgement.

The circuit illustrated in Figure 7 implements the summation operation of equation (4) using latches, logic gates and one presettable counter. The output of the ADC is latched in the n bit latch 48 at the sampling frequency $2f_B$. This value is then compared with successive values of ADC which are produced at the oversampling frequency $f_S$. This comparison is performed using n exclusive OR gates and inverters 50. The output of these gates and the oversampling clock are added together to give the counting signal driving the presettable down counter 52. The counter is presetted to M-1 by wiring all its m preset inputs to 1. The comparison circuit will then produce $\ell$-1 counts for the first $\ell$ ADC outputs that are the same. Using these counts to decrement the counter a value of

$$(M - 1) - (\ell - 1) = M - \ell$$

is obtained at the output of the counter. This is the second term in the Equation 4. The first term is obtained by the output of the n bit latch 48.

These two partial results are latched together in an n + m bit latch 54 and can be clocked at $2f_B$ to produce the output stream. The output of the down counter 52 is ready when $\ell$- 1 down counts are made; that is the ADC output has changed. Therefore in general the output is ready before the M oversampled ADC outputs have arrived and been compared. A data-ready signal can be provided to indicate the end of the accumulation process.

EXAMPLES FOR SYSTEMS IN FIGURE 7 AND FIGURE 8

$n = 2$

$M = 4$

$x = [0,1,2,3]$

output stream

| x(4) | x(3) | x(2) | x(1) | x(1) | M - $\ell$ | | |
|------|------|------|------|------|------|------|------|
| 2 | 1 | 1 | 1 | 01 | 01 | $\Rightarrow$ 0101 = 5 | |
| 3 | 3 | 3 | 2 | 10 | 11 | $\Rightarrow$ 1011 = 11 | |

Referring to Figure 8, 56 is an m + n bit presettable down counter. The most significant n bits are fed from the oversampling ADC output. The remaining m bits are tied to logic '1'.

Block 58 is an m + n bit latch which provides stable parallel output signals during $2f_B$ periods.

CIRCUIT OPERATION

Consider the case when n = 2 and m = 2. In this situation a four times sampling frequency will result in the gain of 2 bits.

At the start of the $2f_B$ cycle the first sample will be preset in the counter. Due to the synchronisation of the $2f_B$ and $2^m.2f_B$ clocks, the counter will not be decremented at this time. At time $1/2^m.2f_B$ later, the next sample will be available. This is compared with the first sample by the ex-OR gate. Since there are used only up to 1 $\ell$.s.b. of interpolation, any change in the samples in any $\frac{1}{2}$ $f_B$ period will be limited to 1 $\ell$.s.b. and hence can be observed in a change in the $\ell$.s.b. of the new sample. If this value is the same as the first one, then the counter will be decremented.

During subsequent samples in the $\frac{1}{2}$ $f_B$ period the counter is decremented at F = $2^m.2f_B$ until an input transition is recorded. To complete the $\frac{1}{2}$ $f_B$ period, the final value reached is latched at the output.

Consider the code sequence 1,1,1,2. over one cycle at intervals $t_0$, $t_1$, $t_2$, $t_3$,

| TIME | ADC VALUE (dec.) | COUNTER OUTPUT (binary) | LATCH OUTPUT |
|------|------|------|------|
| $t_0$ | 1 | 0111 | |
| $t_1$ | 1 | 0110 | Previous $\bar{x}$ |
| $t_2$ | 1 | 0101 | value |
| $t_3$ | 2 | 0101 | 0101 |
| $t_4$ | $x^+$ | $x^+11$ | |

OR consider the sequence 2,3,3,3

| | | | |
|------|------|------|------|
| $t_0$ | 2 | 1011 | |
| $t_1$ | 3 | 1011 | Previous |
| $t_2$ | 3 | 1011 | value |
| $t_3$ | 3 | 1011 | |
| $t_4$ | $x^+$ | $x^+11$ | 1011 |

The analogue transversal filter 30 should have a sample and hold at its output, i.e. between the tranversal filter 30 and the smoothing filter 31, operating at a rate of $2f_B$ for its action to be a direct equivalent of the resettable accumulator used in the A to D converter. Resampling is essential in order to obtain a full one bit per octave increase in resolution with wide band input signals. If the signal bandwidth is very much less than $f_B$, then neither the transversal filter 30 nor resampling would be necessary and a very simple low-pass filter is all that would be required. Other sampled data analogue filters could be implemented which would provide the same result as the transversal filter plus sample and hold. The optimum arrangement would depend on the engineering trade-offs which proved most suitable for a given application.

'Resampling' when used at the output of the transversal filter 30 is a process by which some of the analogue sample values produced by the D-A converter are ignored. The transversal filter 30 in effect adds together a fixed number of sample values. As with the digital accumulation, the correct sum is only present at certain points in time, and it must be acquired using the sample/hold. The action of this sample/hold is equivalent to that of the digital latch 18 in Figure 1. The purpose of the 'oversampling dock' $f_S$ ($= 2^m.2f_B$) in the circuit which can replace accumulator 16 in Figure 1 is to ensure that the addition or subtraction action of the counter 56 in Figure 8 or 52 in Figure 7 is at the same rate as the addition operations which would take place in the accumulator 16.

## USE OF ($2^{n-m} + r$) LEVEL A to D AND D to A CONVERTER

One feature of this conversion technique is that a small loss of input dynamic range occurs when a $2^{n-m}$ level converter is employed in the system. Ideally, an n bit converter should provide outputs which correspond to $2^n$ different levels; with this system, some of these levels are lost because the $2^{n-m}$ level dynamic range must be used partly for the interpolation signal and partly for the main signal. If one $l$.s.b. of interpolation is used, then the number of levels which the main signal can excurse is ($2^{n-m}-1$). This loss of range may be unimportant when, for example, n-m = 16. In an integrated circuit implementation of this system, it would be advantageous to use a ($2^{m-n} + r$) level converter, where r is small and equals the number of $l$.s.b.'s of interpolation used. This is preferable to using a $2^{m-n+1}$ level converter as (a) much less silicon area is needed, and (b) faster effective operation of the converter becomes possible by making use of the much reduced one $l$.s.b. conversion time as explained under 'increased performance using improved $l$.s.b. conversion times'. It is instrumentally easier to achieve fast one $l$.s.b. conversion times in an r level converter where the r levels change one at a time than in a conventional binary converter (particularly for D to A conversion).

For example, a ($2^{m-n} + 1$) level flash A to D could be produced by adding only one extra comparator and a $2^{m-n} + 1$ level binary weighted current D to A could be produced by adding an extra one $l$.s.b. current source. The r level part of the converter would be controlled separately from the $2^{m-n}$ level part. In the D to A application this separate control would reduce the amplitude of switching transients.

A conventional binary D to A is not optimum for obtaining minimum one $l$.s.b. conversion time as the worst case figure must be used and due to the m.s.b. switching transient, this occurs at the one $l$.s.b. code change of 01111.... to 1000...., (a full scale conversion time would be measured with a code change of 0000.... to 1111....). With conventional binary D/A converters, major bit transition such as 01111 to 10000 can occur with an effective one $l$.s.b. change in signal level. The switching transients which correspond to these changes are at amplitudes near the m.s.b. level rather than the $l$.s.b. level. The extra r levels change only one $l$.s.b. at a time and any switching transients introduced are always smaller than those due to m.s.b. transitions. Additional control logic will be required in order to select the r level portion of the D/A converter. Many arrangements are possible, depending on the value of r, but in its simplest form, the carry output of the counter 25 can be used to select the extra $l$.s.b. when r = 1.

## SIMPLIFICATION OF D to A DIGITAL CIRCUITRY

Simplification of the counter circuit is also possible when a $2^{m-n} + 1$ level D to A is used: instead of an n-bit counter, an n-m bit latch plus an m-bit counter can be used. The n-m most significant bits of the input word would go straight to the (n-m) binary input portion of the D/A. The m least significant bits of the n-bit input words would preset an m-bit up-counter, and the carry output of this counter would control the $l$.s.b. portion of the D/A. This approach can be extended to cover the r level case and offers a saving in logic circuitry and the possibility of faster circuit operation.

# IMPROVING THE FIGURE OF MERIT OF DIGITAL TO ANALOGUE CONVERTERS BY USING INTERPOLATION

Indexing terms: digital to analogue conversion, interpolation

An interpolative scheme is described which enables increased resolution to be obtained by utilizing the potentially fast settling time of one least significant bit (LSB) change in a digital to analogue converter (DAC). Results of experimental measurements indicate close to theoretical improvement is achievable in practice. The use of the arrangement in an integrated circuit design is likely to offer significant advantages in terms of lower production and testing costs than a conventional DAC of equivalent performance.

There is reported preliminary results of work aimed at improving the performance of an interpolative DAC. Interpolation achieves increased resolution from a DAC by alternately switching its output between adjacent levels. Time averaging of the DAC output using appropriate filtering can enable additional levels to be resolved between the DAC output levels and this has been likened to a process of linear interpolation [1]. Previous work reported in this area has been aimed mainly at the development of integrated circuit codecs for speech transmission using companded pulse-code modulator [2]. Maximum conversion speed and soope of of this approach was limited by a need for relatively complex digital circuitry and a special purpose DAC which converted on a level-at-a-time basis. In contrast with this earlier work, this letter describes an arrangement which offers the promise of much higher conversion speeds and a wider field of application because very simple digital circuitry is used and the arrangement works with conventional DAC designs.

The definition of figure of merit of an analogue-to-digital converter as used in the specification is the resolution in bits multiplied by conversion frequency. For a digital-to-analogue converter the figure of merit is the product of its resolution in bits and the inverse of its full-scale settling time (bits x hertz).

Linear interpolation can be thought of as trading a reduction in effective conversion speed (Hertz) for an increase in effective resolution (bits), with no alteration in the figure of merit. The theoretical rate of exchange being therefore a one bit increase for every octave of speed reduction.

Whilst this exchange rate can be an attractive proposition for many applications, there are of course some in which the consequent increase in full-scale conversion time would be unacceptable. An arrangement is proposed which should enable a very much better rate of exchange to be obtained, resulting in an increase in the figure of merit.

EXPERIMENT Figure 13 shows the experimental arrangement. The digital circuitry required consists of a presettable up/down counter 60. In the experiment a commercially available 16 bit DAC 62 was used to examine the practical limits of the technique. The test signal source was a low distortion digital sinewave generator 64 which produced data words at a rate of 50,000 per second.

Experimental measurements were first made using only the eight most significant bits of the DAC in order to minimise the influence of DAC linearity errors and switching transients. This was followed by measurements using sinewave data which generated an output waveform of peak amplitude -40dB relative to maximum available from the DAC, and centred on the mid scale point of the DAC. In this quantising noise ratios were measured using a total harmonic distortion analyzer.

RESULTS: A computer program was written which used signal-flow graph theory [3] to predict the likely improvement in baseband signal to quantising noise ratio and the amplitude-frequency distribution of the quantising noise. This analysis predicted a baseband improvement of 4.26dB with interpolation waveform 1 shown in Figure 14(a), 5.80dB with waveform 2 in Figure 14(b) and 5.99dB with waveform 3 in Figure 14(c) after the waveforms were low-pass filtered. Each of these waveforms has an average value of one half an LSB and in theory the use of an integrate and dump filter at the DAC output would enable the ideal figure of 6dB improvement to be obtained with any of the waveforms. Practical measurements using the eight most significant bits of the DAC and a 20kHz low-pass filter with a stop-band attenuation of better than 96dB, gave signal to quantising noise ratio improvements of (a) 4.2dB, (b) 5.8dB, (c) 5.85dB for waveforms 1, 2 and 3 respectively, showing very close agreement with the predicted values.

In the -40dB test, signal to quantising noise ratios significantly worse than theoretical were obtained and investigations revealed that this was due primarily to switching transients (glitches) occurring when data inputs changed. The output data rate of the counter can be up to eight times more than its input rate and therefore the repetition frequency of the DAC transients can be up to 400 kHz. The importance of using a track-hold to remove such glitches is well recognised, particularly with DACs intended for digital audio.

In higher speed applications, this requirement for a fast track-hold may be undesirable as the design of such a device can present significant problems.

FIGURE OF MERIT IMPROVEMENT: The minimum time between the n bit input words (conversion time) in the interpolative arrangement of Figure 13 is simply the full scale settling time plus the time required for the sequence of LSB changes needed to produce the interpolation waveform. With most conventional DACs, the worst case LSB settling time is comparable with the full scale settling time owing to glitches which occur at input code changes. In practice, therefore, a figure of merit is calculated using a conversion time based on the full scale settling figure. The $2^m + 1$ level DAC arrangement of Figure 15 together with a simplified up/down counter system is suggested as a way of increasing the figure of merit available by using interpolation. In the proposed system, the m most significant bits of the n bit word are presented to the m bit conventional section of the DAC for the duration of the conversion period. The n-m least significant bits are loaded into an n-m stage pre-settable up/down counter and with the use of appropriate control signals the carry output of the counter provides the waveform to control the interpolation stage of the DAC. Glitches are now no worse a problem than with a conventional DAC as the interpolation stage is inherently glitch free. The settling time for the interpolation stage should therefore be very much less than the LSB settling time for the conventional section of the DAC. This should reduce the total conversion time required significantly, with a corresponding increase in the figure of merit. Ideally the interpolation stage should be matched to the LSB stage of the conventional part of the DAC and therefore the proposed arrangement is likely to be of most use in an integrated circuit. The reduced complexity of the counter should facilitate faster operation at the integrated circuit level and reduce the area of silicon required.

Very good agreement has been obtained between theoretical predictions of signal to quantising noise ratios produced by an interpolative decoder and experimental measurements. Code-dependent switching transients have been found to be a major limitation to the application of interpolative techniques to high speed digital to analogue conversion. In the light of this work a modified LSB switching arrangement has been proposed which would eliminate the switching transient problem at the LSB level. Owing to the much reduced LSB settling time, it would enable far better resolution to be obtained for a given full scale settling figure than previously reported interpolative arrangements. It is likely that the area of silicon required for the proposed interpolative DAC will be much less than for a conventional DAC with an equivalent resolution and full-scale settling time. In the limit, it is in principle possible to use an extremely fast low-resolution DAC to suit a wide range of lower-speed higher-resolution applications. An added advantage is that high-resolution conventional DACs ideally require time consuming level-at-a-time tests in order to fully characterise their performance. Because of this, full testing of high-resolution DACs in a production environment can be uneconomic. As the analogue section of an interpolative DAC is ideally of low resolution, full testing of this can be accomplished in a relatively short time and as the time required to test the remaining digital circuitry is insignificant it should prove economic to undertake full testing of interpolative DAC integrated circuits on a routine basis.

REFERENCES

1 RITCHIE G.R., CANDY J.C., and NINKE W.H.: "Interpolative digital to analog converters", IEEE Transactions on Communications, 1974, 22, pp. 1797-1806.
2 WOOLEY B.A., FOWLIS D.C., HENRY J.L., WILLIAMS C.E.: "An interpolative PCM decoder", IEEE Journal of Solid-State Circuits, 1979, 14, pp. 20-25.
3 HUGGINS W.H.: "Signal-flow graphs and random signals", Proc. IRE, 1957, 45, pp. 74-86.

INCREASED PERFORMANCE USING IMPROVED LSB CONVERSION TIMES

Most practical D to A converters are able to convert a signal change of one $\ell$.s.b. amplitude in less time than a signal change of full scale amplitude. All previous estimates of the improvements available using the method described in the patent specification have been based on only full scale conversion times as this is the conventional measure of conversion speed.

If the full scale conversion time is $T_L$ and the time available for conversion is $T_C (= \frac{1}{2} f_S)$ then the improvement in resolution would be

$$\log_2 \frac{T_C}{T_L}$$

bits.

By making use of the fact that the one $\ell$.s.b. conversion time is always less than the full scale conversion time, a further improvement in resolution can be obtained. In order to calculate this improvement, assume $T_C = 2^m . T_L$, $T_L = 2^k . T_S$, and $T_C = 2^{m+k} . T_S$, where $T_S$ is the one $\ell$.s.b. conversion time.

The first conversion must be able to cope with up to a full scale change and therefore the time remaining for $\ell$.s.b. conversions is $T_C - T_L$. An improvement of q bits more than can be obtained with just using $T_L$ is shown by the following equations.

$$q = \log_2 \left[ \frac{T_C - T_L}{T_S} + 1 \right] - \log_2 \frac{T_C}{T_L}$$

$$= \log_2 \left[ 2^{m+k} - 2^k + 1 \right] 2^{-m}$$

$$= \log_2 \left[ 2^k - 2^{k-m} + 2^{-m} \right]$$

One conclusion which can be deduced from this equation is that if m is large, then it is possible to increase the resolution by up to k bits, giving a total improvement of almost $m + k$ bits. In a given application it may be beneficial to increase the linearity of the converter at the expense of some of the $m + k$ bits improvement in resolution.

## INTERPOLATION WAVEFORM AMPLITUDE

The following information has been obtained on the amplitude of the interpolation waveform from the generator 13 in Figure 1. This information has been obtained as a result of simulations with a 5 bit ideal quantizer. Neglecting the effect of over load :-

$iw^*$      Ideal interpolation waveform amplitude/step size.

$iw_{(3dB)}$      Waveform range that gives ±3dB SNR of the maximum.

$iw_{3dB/Oct)}$      Waveform range that gives better than 3dB/Octave improvement.

Approximate amplitude ranges as a function of N = over-sampling factor.

$$iw_{(3dB)} \gtrless \left(1 \pm \frac{1}{2^N}\right) iw^*$$

$$iw_{(3dB/Oct)} \gtrless 2^{N-1} \left(1 \pm \frac{2^{N+1} - N}{2^{N+1} + 1}\right) iw^* \quad \text{First Cycle}$$

These results are illustrated in Figures 9 to 12.

Now that embodiments of the invention have been described, it will be clear that the invention can be put into practice in many other ways. For a further increase in accuracy or better smoothing the present invention may be combined with the previously mentioned known apparatus and methods of oversampling.

An application of the improvement of resolution can be obtained by making use of a system which combines a fast one $\ell$.s.b. conversion with a conventional full scale conversion. The improvement available can be seen by way of the following example:-

Using the prior art of oversampling, an 8 bit A to D converter with a full scale conversion time of 100ns can be used to provide a 12 bit resolution conversion by averaging 256 successive full scale conversions, giving a total conversion time of 25,600ns. i.e. nanoseconds.

With the technique described in U.K. Patent Application 8320534 (GB-A-2144285) 12 bit resolution could be obtained from the same A to D by using 32 successive full scale conversions, giving a total conversion time of 3,200ns. In an A to D converter system which provides for both conversion of sull scale signals and successive signals which are different in amplitude by only one $\ell$.s.b., two types of A to D converters are usually required. In this case, a one $\ell$.s.b. conversion may typically be completed in one tenth of the time for a full scale conversion. By making use of this faster one $\ell$.s.b. conversion in the present example, 12 bit resolution could be obtained by making one full scale 8 bit conversion (in 100ns) followed by 31 successive one ℓ.s.b. conversions (each taking 10ns). The total conversion tine is now reduced to 410ns demonstrating a significant improvement in conversion speed over both prior art and the GB-A-2144285. If, instead of reducing the conversion time, the aim were to obtain the maximum resolution for a given conversion time (e.g. 25,600ns), then this comparison would give the following results:

Prior art: 12 bits; GB-A-2144285: 16 bits; this Application: 19 bits.

**Claims**

1.  An n + m bit analog-to-digital converter circuit including

    an analog input and n + m output bits, n and m being integers,

    a sample and hold circuit [11] having an input terminal [10] receiving an analog input signal, a control input terminal, an output terminal, and means for applying a first sampling signal having a first frequency to the control input terminal to cause the sample and hold circuit to produce a sampled analog signal on the output terminal,

    an interpolation signal generating circuit [13] producing a periodic interpolation signal having a second frequency,

    a combining circuit [12] combining the interpolation signal and the sampled analog signal to produce a combined signal,

    an n-bit analog-to-digital converter [15] receiving the combined signal and converting it to n-bit digital numbers in response to a conversion control signal of the second frequency,

    digital time averaging circuit means [16] for accumulating the n-bit digital numbers produced during each period of the first frequency and averaging the accumulated total thereof over that period, characterized by:

    the n-bit analog-to-digital converter [15] having accuracy less than m + n bit accuracy, the second frequency is $2^m$ times the first frequency, the combined signal having $2^m$ steps in each period of the sampling signal, and the analog-to-digital converter having a quantizing interval [d1] which is no more than

$$\left[ \frac{p}{2} \left( 1 - \frac{2p - \log_2 p}{2p + 1} \right) \right]^{-1}$$

    times the magnitude of the change effected by the combining circuit on the sampled analog signal in one period of the interpolation signal, wherein $p = 2^m$, and wherein the maximum excursion of the interpolation signal is at least as great as the quantizing interval;

    the digital time-averaging circuit means producing the averaged accumulated total as n + m bit digital numbers;

    an n + m bit latching circuit [18] for receiving and latching the n + m bit digital numbers, and

    means for sampling the n + m bit latching circuit at a rate equal to the first frequency to produce n + m bit digital numbers accurately representative of the analog input signal.

2.  An n + m bit analog-to-digital converter circuit including

    an analog input and n + m output bits, n and m being integers,

    a sample and hold circuit [11] having an input terminal [10] receiving an analog input signal, a control input terminal, an output terminal, and means for applying a first sampling signal having a first frequency to the control input terminal to cause the sample and hold circuit to produce a sampled analog signal on the output terminal,

    an interpolation signal generating circuit [13] producing a periodic interpolation signal having a second frequency,

    a combining circuit [12] combining the interpolation signal and the sampled analog signal to produce a combined signal,

    an n-bit analog-to-digital converter [15] receiving the combined signal and converting it to n-bit digital numbers in response to a conversion control signal of the second frequency,

    digital time averaging circuit means [16] for accumulating the n-bit digital numbers produced during each period of the first frequency and averaging the accumulated total thereof over that period,

    characterised by:

the n-bit analog-to-digital converter [15] having accuracy less than m+n accuracy, the second frequency is $2^m$ times the first frequency, the combined signal having $2^m$ steps in each period of the sampling signal, and the analog-to-digital converter having a quantizing interval which is no more than

$$\left[\frac{p}{2}\left(1 - \frac{2p - \log_2 p}{2p + 1}\right)\right]^{-1}$$

times the magnitude of the change effected by the combining circuit on the sampled analog signal in one period of the interpolation signal, wherein $p = 2^m$;

the digital time-averaging circuit means producing the averaged accumulated total as n+m bit digital numbers;

an n+m bit latching circuit [18] for receiving and latching the n+m bit digital numbers, and

means for sampling the n+m bit latching circuit at a rate equal to the first frequency to produce n+m bit digital numbers accurately representative of the analog input signal wherein the interpolation signal has a stepped waveform and a repetition frequency equal to the first frequency, and the interpolation signal has a maximum excursion of at least

$$\frac{2^m - 1}{2^m}$$

times the quantizing interval, each step having a duration equal to the period of the second frequency and a magnitude equal to the magnitude of the interpolation signal divided by the number of step transitions in each period of the first frequency.

3. A method of converting an analog signal to a digital number, the method including

sampling a level of the analog signal at a first frequency and holding each sampled level until a next sampled level is obtained,

combining each sampled and held level with an interpolation signal having a second frequency to produce a combined signal,

operating an n-bit analog-to-digital converter to convert each level of the combined signal to digital numbers, and

averaging the digital numbers,

characterized by:

the second frequency being $2^m$ times the first frequency so that the combined signal has $2^m$ steps during each period of the first frequency, m being an integer,

the analog-to-digital converter having a quantizing interval [d1] which is no more than

$$\left[\frac{p}{2}\left(1 - \frac{2p - \log_2 p}{2p + 1}\right)\right]^{-1}$$

times the magnitude of the change effected in one period of the interpolation signal by combining the interpolation signal with the sampled level held, wherein $p = 2^m$, and wherein the maximum excursion of the interpolation signal is at least as great as the quantizing interval,

operating the n-bit analog-to-digital converter to convert the level of each of the $2^m$ steps to $2^{m+n}$ bit digital numbers,

time-averaging the $2^{m+n}$ bit digital numbers in each period of the first frequency to produce an n+m bit digital number for each period of the first frequency,

storing each of the n+m bit digital numbers in a latch and sampling the stored n+m bit digital numbers at a rate equal to the first frequency to produce n+m bit digital numbers which accurately represent the analog input signal, and

repeating the foregoing steps for successive periods of the first frequency.

4.  A digital-to-analog conversion device including:

means for holding successive values of an n-bit digital signal to be converted one at a time, successive values of the n-bit digital signal being substituted at a first frequency,

means for combining an output signal of the holding means with an interpolation signal that is periodic at a second frequency,

a digital-to-analog converter [28],

means [30] for averaging the analog output signal,

characterized by:

the second frequency being $2^m$ times the first frequency, m being a positive integer;

the combining means including an n-bit counter [25] for producing an n-m bit output signal, means for setting the counter to the current value of the n-bit digital signal at the first frequency and means for incrementing or decrementing the counter at the second frequency during each period of the first frequency so that there are $2^m$ times more values of the n-m bit output signal than of the n-bit digital signal, wherein the holding means and the combining means together comprise the counter [25], the means for setting the counter at the first frequency, and the means for incrementing or decrementing the counter at the second frequency during each period of the first frequency, the counter [25] produces a carry signal [29];

logic gating means [27] for coupling bit levels of the n-m bit output signal to n-m bit input terminals, respectively, of the n-m bit digital-to-analog converter [28], the logic gating means including n-m OR gates each having an input terminal receiving the carry signal and an input terminal receiving a respective bit level of the n-m bit output signal;

the digital-to-analog converter [28] being an n-m bit digital-to-analog converter coupled to the n-m bit output signal and operating in response to a control signal that is periodic at the second frequency to convert each of the values of the n-m bit output signal to a corresponding analog value to produce an analog output signal having $2^m$ analog values for each value of the n-bit digital signal, the digital-to-analog converter having a quantizing interval which is no more than

$$\left[ \frac{p}{2} \left( 1 - \frac{2p - \log_2 p}{2p + 1} \right) \right]^{-1}$$

times the magnitude of the change effected in one period of the interpolation signal by combining the interpolation signal with the sampled signal held, wherein $p = 2^m$, and wherein the maximum excursion of the interpolation signal is at least as great as the quantizing interval; and

the analog output signal having a bandwidth $f_B$, and the first frequency is at least $2f_B$.

5.  A method of converting a plurality of digital signals to an analog signal including holding values of an n-bit digital signal to be converted one at a time and sampling successive values of the n-bit digital signal at a first frequency, combining the sampled signal with an interpolation signal that is periodic at a second frequency, converting bit levels of the resulting combined signals to inputs of a digital-to-analog converter, and averaging the analog output signal produced by the digital-to-analog converter,

characterized by:

combining the held signals with the interpolation signal by means of a n-bit counter by setting the n-bit counter to current values of the n-bit digital signal at the first frequency, and incrementing or decrementing the n-bit counter at the second frequency during each period of the first frequency,

the second frequency being $2^m$ times the first frequency to produce an n-m bit output signal, m being a positive integer; and

coupling bit levels of the n-m bit output signal to n-m input terminals, respectively, of an n-m bit digital-to-analog converter [28], passing the n-m most significant bits of the counter [25] to n-m input terminals, respectively, of the n-m bit digital-to-analog converter by means of n-m OR gates, one input terminal of each of the OR gates being connected to a carry output terminal of the n-bit counter, the digital-to-analog converter having a quantizing interval which is no more than

$$\left[\ \frac{p}{2}\ (\ 1\ -\ \frac{2p\ -\ \log_2 p}{2p\ +\ 1}\ )\ \right]^{-1}$$

times the magnitude of the change effected in one period of the interpolation signal by combining the interpolation signal with the sampled signal held, wherein $p = 2^m$, wherein the maximum excursion of the interpolation signal is at least as great as the quantizing interval.

**Patentansprüche**

1.  n + m-Bit Analog-/Digitalwandlerschaltung mit
    einem analogen Eingang und n + m Ausgangsbits, wobei n und m ganze Zahlen sind,
    einer Tastspeicherschaltung (11) mit einem ein analoges Eingangssignal empfangenden Eingangsanschluß (10), einem Steuereingangsanschluß, einem Ausgangsanschluß sowie Mitteln zum Anlegen eines ersten Tastsignals mit einer ersten Frequenz an den Steuereingangsanschluß, um zu veranlassen, daß die Tastspeicherschaltung ein abgetastetes analoges Signal auf dem Ausgangsanschluß erzeugt, einer Interpolationssignal-Generatorschaltung (13), die ein periodisches Interpolationssignal mit einer zweiten Frequenz erzeugt,
    einer das Interpolationssignal und das abgetastete analoge Signal zur Erzeugung eines kombinierten Signals kombinierenden Kombinierschaltung (12),
    einem n-Bit Analog-/Digitalwandler (15), der das kombinierte Signal aufnimmt und es in n-Bit Digital-Zahlen als Reaktion auf ein Umwandlungssteuersignal der zweiten Frequenz umwandelt,
    bleiben: digitale Zeit-Mittelwert bildenden Schaltungsmitteln (16) zum Akkumulieren der während jeder Periode der ersten Frequenz erzeugten n-Bit Digitalzahlen und zur Durchschnittsbildung ihrer akkumulierten Summe über diese Periode, dadurch gekennzeichnet, daß:
    der n-Bit Analog-/Digitalwandler (15) eine kleinere Genauigkeit als m + n-Bit Genauigkeit aufweist, die zweite Frequenz $2^m$ mal der ersten Frequenz ist, das kombinierte Signal $2^m$ Stufen in jeder Periode des Tastsignals aufweist und der Analog-/Digitalwandler ein Quantisierungsintervall (d1) aufweist, das nicht mehr als

$$\left[\ \frac{p}{2}\ (\ 1\ -\ \frac{2p\ -\ \log_2 p}{2p\ +\ 1}\ )\ \right]^{-1}$$

mal der Größe der von der Kombinierschaltung auf das abgetastete analoge Signal in einer Periode des Interpolationssignals bewirkten Änderung ist, wobei $p = 2^m$ und
    wobei die maximale Elongation des Interpolationssignals mindes-tens so groß wie das Quantisierungsintervall ist; die digitalen Zeitdurchschnittsbildungsschaltmittel die gemittelte akkumulierte Summe als n + m-Bit Digital-Zahlen erzeugen;
    und gekennzeichnet durch eine n + m-Bit Verriegelungsschaltung (18) zur Aufnahme und zum Verriegeln der n + m-Bit Digital-Zahlen, und
    durch Mittel zum Abtasten der n + m-Bit Verriegelungsschaltung mit einer der ersten Frequenz gleichen Geschwindigkeit zur Erzeugung von n + m-Bit Digitalzahlen, die genau das analoge Eingangssignal darstellen.

2.  n + m-Bit Analog-/Digitalwandlerschaltung mit
    einem analogen Eingang und n + m Ausgangsbits, wobei n und m ganze Zahlen sind,
    einer Tastspeicherschaltung (11) mit einem ein analoges Eingangssignal aufnehmenden Eingangsanschluß (10), einem Steuereingangsanschluß, einem Ausgangsanschluß und Mitteln zum Anlegen eines ersten Abtastsignals mit einer ersten Frequenz an den Steuereingangsanschluß, um zu veranlassen, daß die Tastspeicherschaltung ein abgetastetes analoges Signal auf dem Ausgangsanschluß erzeugt, einer Interpolationssignal-Generatorschaltung (13), die ein periodisches Interpolationssignal mit einer zweiten Frequenz erzeugt,
    einer das Interpolationssignal und das abgetastete analoge Signal zur Erzeugung eines kombinierten Signals kombinierenden Kombinierschaltung (12),
    einem n-Bit Analog-/Digitalwandler (15), der das kombinierte Signal aufnimmt und es in n-Bit Digitalzahlen als Reaktion auf ein Umwandlungssteuersignal der zweiten Frequenz umwandelt,
digitalen Zeitdurchschnittsbildungsschaltmitteln (16) zum Akkumulieren der während jeder Periode der ersten Frequenz erzeugten n-Bit Digitalzahlen und zur Durchschnittsbildung ihrer akkumulierten Summe über diese Periode,

dadurch gekennzeichnet, daß:

der n-Bit Analog-/Digitalumwandler (15) eine geringere Ge- nauigkeit als n + m Genauigkeit aufweist, die zweite Frequenz $2^m$ mal der ersten Frequenz ist, das kombinierte Signal $2^m$ Stufen in jeder Periode des Abtastsignals aufweist und der Analog-/Digitalwandler ein Quantisierungsintervall aufweist, das nicht mehr als

$$\left[ \frac{p}{2} \left( 1 - \frac{2p - \log_2 p}{2p + 1} \right) \right]^{-1}$$

mal der Größe der von der Kombinierschaltung auf das abgetastete analoge Signal in einer Periode des Interpolationssignals bewirkten Änderung ist, wobei $p = 2^m$; die digitalen Zeitdurchschnittsbildungsschaltmittel die gemittelte akkumulierte Summe als n + m-Bit Digitalzahlen erzeugen,
desweiteren gekennzeichnet durch eine n + m-Bit Verriegelungsschaltung (18) zur Aufnahme und zum Verriegeln der n + m-Bit Digitalzahlen, und
durch Mittel zum Abtasten der n + m-Bit Verriegelungsschaltung mit einer der ersten Frequenz gleichen Geschwindigkeit zur Erzeugung von das analoge Eingangssignal genau darstellenden n + m-Bit Digitalzahlen, wobei das Interpolationssignal eine Stufenwellenform und eine der ersten Frequenz gleiche Wiederholungsfrequenz aufweist und das Interpolationssignal eine maximale Elongation von mindesten

$$\frac{2^m - 1}{2^m}$$

mal dem Quanti$^S$ierungsintervall aufaufweist und jede Stufe eine der Periode der zweiten Frequenz gleiche Dauer und eine der Größe des Interpolationssignals, geteilt durch die Zahl der Stufenübergänge in jeder Periode der ersten Frequenz, gleiche Größe aufweist.

3.  Verfahren zum Umwandeln eines Analogsignals in eine Digitalzahl, wobei das Verfahren das Abtasten eines Werts des analogen Signals bei einer ersten Frequenz und das Halten jedes abgetasteten Werts bis zum Erhalten eines nächsten abgetasteten Werts, das Kombinieren jedes abgetasteten und gespeicherten Werts mit einem Interpolationssignal einer zweiten Frequenz zur Erzeugung eines kombinierten Signals, das Betreiben eines n-Bit Analog-/Digitalwandlers zum Umwandeln jedes Werts des kombinierten Signals in Digitalzahlen und die Durchschnittsbildung der Digitalzahlen umfaßt, dadurch gekennzeichnet, daß die zweite Frequenz $2^m$ mal der ersten Frequenz ist, so daß das kombinierte Signal $2^m$ Stufen während jeder Periode der ersten Frequenz aufweist, wobei m eine ganze Zahl ist, daß der Analog-/Digitalwandler ein Quantisierungsintervall (d1) aufweist, das nicht mehr als

$$\left[ \frac{p}{2} \left( 1 - \frac{2p - \log_2 p}{2p + 1} \right) \right]^{-1}$$

mal der Größe der in einer Periode des Interpolationssignals durch Kombinieren des Interpolationssignals mit dem abgetasteten und gespeicherten Wert bewirkten Änderung ist, wobei $p = 2^m$, und worin die maximale Elongation des Interpolationssignals mindestens so groß wie das Quantisierungsintervall ist,
daß der n-Bit Analog-/Digitalwandler zum Umwandeln des Werts jedes der $2^m$ Schritte in $2^{m+n}$-Bit Digitalzahlen betrieben wird,
daß die $2^{m+n}$-Bit Digitalzahlen in jeder Periode der ersten Frequenz zeitgemittelt werden, zur Erzeugung einer n + m-Bit Digitalzahl für jede Periode der ersten Frequenz,
daß jede der n + m-Bit Digitalzahlen in einem Speicher gespeichert und die gespeicherten n + m-Bit Digitalzahlen mit einer Geschwindigkeit abgetastet werden, die der ersten Frequenz gleich ist, zur Erzeugung von n + m-Bit Digitalzahlen, die das analoge Eingangssignal genau darstellen, und daß die vorausgehenden Schritte für aufeinanderfolgende Perioden der ersten Frequenz wiederholt werden.

4. Digital-/Analogumwandlergerät, enthaltend:
Mittel zum Speichern aufeinanderfolgender Werte eines einzeln zu konvertierenden n-Bit digitalen Signales, wobei aufeinanderfolgende Werte des n-Bit digitalen Signales bei einer ersten Frequenz ersetzt werden, Mittel zum Kombinieren eines Ausgangssignals der Speichermittel mit einem Interpolationssignal, das bei einer zweiten Frequenz periodisch ist,
einen Digital-/Analogwandler (28),
Mittel zur Durchschnittsbildung des analogen Ausgangssignals,
dadurch gekennzeichnet, daß:
die zweite Frequenz $2^m$ mal der ersten Frequenz ist, wobei m eine positive ganze Zahl ist;
die Kombiniermittel einen n-Bit-Zähler (25) zur Erzeugung eines n-m-Bit Ausgangssignals, Mittel Zum Setzen des Zählers auf den augenblicklichen Wert des n-Bit Digitalsignals bei der ersten Frequenz sowie Mittel zum Vergrößern oder Verringern des Zählerinhalts bei der zweiten Frequenz während jeder Periode der ersten Frequenz aufweisen, so daß es $2^m$ mal mehr Werte des n-m-Bit Ausgangssignals als des n-Bit digitalen Signals gibt, wobei die Speichermittel und die Kombiniermittel zusammen den Zähler (25), die Mittel zum Setzen des Zählers bei der ersten Frequenz und die Mittel zum Vergrößern oder Verringern des Zählerinhalts bei der zweiten Frequenz während jeder Periode der ersten Frequenz umfassen und der Zähler (25) ein Übertragssignal (29) erzeugt; durch logische Gattermittel (27) zum Koppeln von Bit-Werten des n-m-Bit Ausgangssignals an n-m-Bit Eingangsanschlüsse bzw. des n-m-Bit Digital-/Analogwandlers (28), wobei die logischen Gattermittel n-m ODER-Gatter aufweisen, von denen jedes einen das Übertragssignal empfangenden Eingang und einen einen entsprechenden Bit-Wert des n-m-Bit Ausgangssignals empfangenden Eingangsanschluß aufweist;
daß der Digital-/Analogwandler (28) eine n-m-Bit Digital-/Analogumwandler ist, der an das n-m-Bit Ausgangssignal gekoppelt ist und als Reaktion auf ein Steuersignal arbeitet, das periodisch bei einer zweiten Frequenz ist, um jeden der Werte des n-m-Bit Ausgangssignals in einen entsprechenden analogen Wert umzuwandeln, zur Erzeugung eines analogen Ausgangssignals mit $2^m$ analogen Werten für jeden Wert des n-Bit digitalen Signals, wobei der Digital-/Analogwandler ein Quantisierungsintervall aufweist, das nicht mehr als

$$\left[ \frac{p}{2} \left( 1 - \frac{2p - \log_2 p}{2p + 1} \right) \right]^{-1}$$

mal der Größe der Änderung ist, die in einer Periode des Interpolationssignals durch Kombinieren des Interpolationssignals mit dem abgetasten und gespeicherten Signal bewirkt wird, wobei $p = 2^m$, und worin die maximale Elongation des Interpolationssignals mindestens so groß wie das Quantisierungsintervall ist, und daß das analoge Ausgangssignal eine Bandbreite $f_B$ aufweist und die erste Frequenz mindestens $2f_B$ ist.

5. Verfahren zum Umwandeln einer Vielzahl von digitalen Signalen in ein analoges Signal, bei dem Werte eines n-Bit digi- talen Signales $_z$ur einzelnen Umwandlung gespeichert und aufeinanderfolgende Werte des n-Bit digitalen Signales bei einer ersten Frequenz abgetastet werden, das abgetastete Signal mit einem Interpolationssignal kombiniert wird, das bei einer zweiten Frequenz periodisch ist, bei dem Bit-Werte der sich ergebenden kombinierten Signale in Eingänge eines Digital-/Analogwandlers konvertiert werden und die von dem Digital-/Analogwandler erzeugten analogen Ausgangssignale gemittelt werden, dadurch gekennzeichnet, daß
die gespeicherten Signale mit dem Interpolationssignal mit Hilfe eines n-Bit-Zählers kombiniert werden, indem der n-Bit-Zähler auf augenblickliche Werte des n-Bit digitalen Signals bei der ersten Frequenz gesetzt wird und der Inhalt des n-Bit-Zähler bei der zweiten Frequenz während jeder Periode der ersten Frequenz erhöht oder verringert wird, wobei die zweite Frequenz $2^m$ mal der ersten Frequenz ist, zur Erzeugung eines n-m-Bit Ausgangssignale, wobei m eine positive ganze Zahl ist, und daß Bit-Werte des n-m-Bit Ausgangssignals an n-m Eingangsanschlüsse bzw. eines n-m-Bit Digital-/Anlalogwandlers (28) gekoppelt werden, daß die n-m signifikantesten Bits des Zählers (25) bzw. des n-

EP 0 142 907 B1

m Bit Digital-/Analogwandlers an n-m Eingangsanschlüsse mit Hilfe n-m ODER-Gattern durchgegeben werden, wobei ein Eingangsanschluß jedes der ODER-Gatter mit einem Übertragsausgangsanschluß des n-Bit-Zählers verbunden ist und der Digital-/Analogwandler ein Quantisierungsintervall aufweist, das nicht mehr als

$$\left[\frac{p}{2}\left(1-\frac{2p-\log_2 p}{2p+1}\right)\right]^{-1}$$

mal der Größe der Änderung ist, die in einer Periode des Interpolationssignals durch Kombinieren des Interpolationssignals mit dem abgetasteten gespeicherten Signals bewirkt wird, wobei $p=2^m$ und die maximale Elongation des Interpolationssignals mindestens so groß wie das Quantietisierungsintervall ist.

**Revendications**

1. Circuit convertisseur analogique-numérique à n + m bits incluant :
   une entrée analogique et n + m bits de sortie, n et m étant des entiers ;
   un circuit échantillonneur-bloqueur (11) comportant une borne d'entrée (10) qui reçoit un signal d'entrée analogique, une borne d'entrée de commande, une borne de sortie, et un moyen pour appliquer un premier signal d'échantillonnage présentant une première fréquence à la borne d'entrée de commande pour forcer le circuit échantillonneur-bloqueur à produire un signal analogique échantillonné sur la borne de sortie ;
   un circuit de génération de signal d'interpolation (13) qui produit un signal d'interpolation périodique présentant une seconde fréquence ;
   un circuit de combinaison (12) qui combine le signal d'interpolation et le signal analogique échantillonné pour produire un signal combiné ;
   un convertisseur analogique-numérique à n bits (15) qui reçoit le signal combiné et qui le convertit en nombres numériques à n bits en réponse à un signal de commande de conversion de la seconde fréquence ;
   un moyen de circuit de moyennage temporel numérique (16) pour accumuler les nombres numériques à n bits produits pendant chaque période de la première fréquence et pour moyenner leur total accumulé sur cette période ;
   caractérisé par ;
   le convertisseur analogique-numérique à n bits (15) présente une précision inférieure à une précision de m + n bits, la seconde fréquence vaut $2^m$ fois la première fréquence, le signal combiné comporte $2^m$ étages dans chaque période du signal d'échantillonnage et le convertisseur analogique-numérique présente un intervalle de quantification (d1) qui n'est pas supérieur à ;

$$\left[\frac{p}{2}\left(1-\frac{2p-\log_2 p}{2p+1}\right)\right]^{-1}$$

fois l'amplitude de la modification effectuée par le circuit de combinaison sur le signal analogique échantillonné pour une période du signal d'interpolation, où $p=2^m$ et où l'excursion maximum du signal d'interpolation est au moins aussi grande que l'intervalle de quantification ;
   le moyen de circuit de moyennage temporel numérique produit le total accumulé moyenné en tant que nombres numériques à n + m bits ;
   un circuit de verrouillage à n + m bits (18) reçoit et verrouille les nombres numériques à n + m bits ; et
   un moyen pour échantillonner le circuit de verrouillage à n + m bits selon une fréquence égale à la première fréquence pour produire des nombres numériques à n + m bits représentant avec précision le signal d'entrée analogique.

2. Circuit convertisseur analogique-numérique à n + m bits incluant ;
   une entrée analogique et n + m bits de sortie, n et m étant des entiers ;

22

un circuit échantillonneur-bloqueur (11) comportant une borne d'entrée (10) qui reçoit un signal d'entrée analogique, une borne d'entrée de commande, une borne de sortie, et un moyen pour appliquer un premier signal d'échantillonnage présentant une première fréquence à la borne d'entrée de commande pour forcer le circuit échantillonneur-bloqueur à produire un signal analogique échantillonné sur la borne de sortie ;

un circuit de génération de signal d'interpolation (13) qui produit un signal d'interpolation périodique présentant une seconde fréquence ;

un circuit de combinaison (12) qui combine le signal d'interpolation et le signal analogique échantillonné pour produire un signal combiné ;

un convertisseur analogique-numérique à n bits (15) qui reçoit le signal combiné et qui le convertit en nombres numériques à n bits en réponse à un signal de commande de conversion de la seconde fréquence ;

un moyen de circuit de moyennage temporel numérique (16) pour accumuler les nombres numériques à n bits produits pendant chaque période de la première fréquence et pour moyenner leur total accumulé sur cette période ;

caractérisé par ;

le convertisseur analogique-numérique à n bits (15) présente une précision inférieure à une précision de m + n bits, la seconde fréquence vaut $2^m$ fois la première fréquence, le signal combiné comporte $2^m$ étages dans chaque période du signal d'échantillonnage et le convertisseur analogique-numérique présente un intervalle de quantification (d1) qui n'est pas supérieur à ;

$$\left[\frac{p}{2}\left(1 - \frac{2p - \log_2 p}{2p + 1}\right)\right]^{-1}$$

fois l'amplitude de la modification effectuée par le circuit de combinaison sur le signal analogique échantillonné pour une période du signal d'interpolation, où $p = 2^m$ ;

le moyen de circuit de moyennage temporel numérique produit le total accumulé moyenné en tant que nombres numériques à n + m bits ;

un circuit de verrouillage à n + m bits (18) reçoit et verrouille les nombres numériques à n + m bits ; et

un moyen pour échantillonner le circuit de verrouillage à n + m bits selon une fréquence égale à la première fréquence pour produire des nombres numériques à n + m bits représentant avec précision le signal d'entrée analogique, dans lequel le signal d'interpolation présente une forme d'onde étagée et une fréquence de répétition égale à la première fréquence et le signal d'interpolation présente une excursion maximum au moins égale à

$$\frac{2^m - 1}{2^m}$$

fois l'intervalle de quantification, chaque étage présentant une durée égale à la période de la seconde fréquence et une amplitude égale à l'amplitude du signal d'interpolation divisée par le nombre de transitions d'étage dans chaque période de la première fréquence.

3. Procédé de conversion d'un signal analogique en un nombre numérique, le procédé incluant :

l'échantillonnage d'un niveau du signal analogique à une première fréquence et le blocage de chaque niveau échantillonné jusqu'à ce qu'un niveau échantillonné suivant soit obtenu ;

la combinaison de chaque niveau échantillonné et bloqué à un signal d'interpolation présentant une seconde fréquence pour produire un signal combiné ;

l'actionnement d'un convertisseur analogique-numérique à n bits pour convertir chaque niveau du signal combiné en nombres numériques ; et

le moyennage des nombres numériques ;

caractérisé par :

la seconde fréquence vaut $2^m$ fois la première fréquence de telle sorte que le signal combiné présente $2^m$ étages pendant chaque période de la première fréquence, m étant un entier ;

le convertisseur analogique-numérique présente un intervalle de quantification (d1) qui n'est pas

supérieur à

$$\left[\frac{p}{2}\left(1 - \frac{2p - \log_2 p}{2p + 1}\right)\right]^{-1}$$

fois l'amplitude de la modification effectuée sur une période du signal d'interpolation en combinant le signal d'interpolation au niveau échantillonné-bloqué, où $p = 2^m$ et où l'excursion maximum du signal d'interpolation est au moins aussi grande que l'intervalle de quantification ;

l'actionnement du convertisseur analogique-numérique à n bits pour convertir le niveau de chacune des $2^m$ étages en nombres numériques à $2^{m+n}$ bits ;

le moyennage temporel des nombres numériques à $2^{m+n}$ bits pour chaque période de la première fréquence pour produire un nombre numérique à n+m bits pour chaque période de la première fréquence ;

le stockage de chacun des nombres numériques à n+m bits dans une bascule et l'échantillonnage des nombres numériques à n+m bits stockés selon une fréquence égale à la première fréquence pour produire des nombres numériques à n+m bits qui représentent avec précision le signal d'entrée analogique ; et

la répétition des étapes qui précèdent pour des périodes successives de la première fréquence.

4. Dispositif de conversion numérique-analogique incluant :

un moyen pour bloquer des valeurs successives d'un signal numérique à n bits qui doivent être converties à raison d'une à la fois, des valeurs successives du signal numérique à n bits étant substituées pour une première fréquence ;

un moyen pour combiner un signal de sortie du moyen de blocage à un signal d'interpolation qui est périodique pour une seconde fréquence ;

un convertisseur numérique-analogique (28) ;

un moyen (30) pour moyenner le signal de sortie analogique,

caractérisé par ;

la seconde fréquence vaut $2^m$ fois la première fréquence, m étant un entier positif ;

le moyen de combinaison inclut un compteur à n bits (25) pour produire un signal de sortie à n-m bits, un moyen pour établir le compteur à la valeur courante du signal numérique à n bits pour la première fréquence et un moyen pour incrémenter ou décrémenter le compteur à la seconde fréquence pendant chaque période de la première fréquence de telle sorte qu'il y ait $2^m$ fois plus de valeurs du signal de sortie à n-m bits que du signal numérique à n bits, où le moyen de blocage et le moyen de combinaison comprennent ensemble le compteur (25), le moyen pour établir le compteur à la première fréquence et le moyen pour incrémenter ou décrémenter la compteur à la seconde fréquence pendant chaque période de la première fréquence, le compteur (25) produisant un signal de retenue (29) ;

un moyen de porte logique (27) pour couper des niveaux binaires du signal de sortie à n-m bits respectivement à des bornes d'entrée à n-m bits du convertisseur numérique-analogique à n-m bits (28), le moyen de porte logique incluant n-m portes OU, chacune comportant une borne d'entrée qui reçoit le signal de sortie et une borne d'entrée qui reçoit un niveau binaire respectif du signal de sortie à n-m bits ;

le convertisseur numérique-analogique (28) étant un convertisseur numérique-analogique à n-m bits coupé au signal de sortie à n-m bits et fonctionnant en réponse à un signal de commande qui est périodique à la seconde fréquence pour convertir chacune des valeurs du signal de sortie à n-m bits en une valeur analogique correspondante pour produire un signal de sortie analogique comportant $2^m$ valeurs analogiques pour chaque valeur du signal numérique à n bits, le convertisseur numérique-analogique présentant un intervalle de quantification qui n'est pas supérieur à :

$$\left[\frac{p}{2}\left(1 - \frac{2p - \log_2 p}{2p + 1}\right)\right]^{-1}$$

fois l'amplitude de la modification effectuée dans une période du signal d'interpolation en combinant le signal d'interpolation au signal échantillonné bloqué, où $p = 2^m$ et où l'excursion maximum du signal d'interpolation est au moins aussi grande que l'intervalle de quantification ; et

le signal de sortie analogique présente une largeur de bande $f_B$ et la première fréquence vaut au moins $2f_B$.

5. Procédé de conversion d'une pluralité de signaux numériques en un signal analogique incluant le blocage de valeurs d'un signal numérique à n bits qui doit être converti à raison d'une à la fois et l'échantillonnage de valeurs successives du signal numérique à n bits à une première fréquence, la combinaison du signal échantillonné à un signal d'interpolation qui est périodique à une seconde fréquence, la conversion de niveaux binaires des signaux combinés résultants en entrées d'un convertisseur numérique-analogique et le moyennage du signal de sortie analogique produit par le convertisseur numérique-analogique ;

caractérisé par :

la combinaison des signaux bloqués au signal d'interpolation au moyen d'un compteur à n bits en établissant le compteur à n bits à des valeurs courantes du signal numérique à n bits pour la première fréquence et en incrémentant ou en décrémentant le compteur à n bits pour la seconde fréquence pendant chaque période de la première fréquence ;

la seconde fréquence vaut $2^m$ fois la première fréquence pour produire un signal de sortie à n-m bits, m étant un entier positif ; et

le couplage de niveaux binaires du signal de sortie à n-m bits respectivement à n-m bornes d'entrée d'un convertisseur numérique-analogique à n-m bits (28), le passage des n-m bits les plus significatifs du compteur (25) respectivement aux n-m bornes d'entrée du convertisseur numérique-analogique à n-m bits au moyen de n-m portes OU, une borne d'entrée de chacune des portes OU étant connectée à une borne de sortie de retenue du compteur à n bits, le convertisseur numérique-analogique présentant un intervalle de quantification qui n'est pas supérieur à

$$\left[\frac{p}{2}\left(1 - \frac{2p - \log_2 p}{2p + 1}\right)\right]^{-1}$$

fois l'amplitude de la modification effectuée sur une période du signal d'interpolation en combinant le signal d'interpolation au signal échantillonné bloqué, où $p = 2^m$ et où l'excursion maximum du signal d'interpolation est au moins aussi grande que l'intervalle de quantification.

Fig. 1

Fig. 2

Fig. 3

Fig. 6

Fig. 4

Fig. 5

n BIT OUTPUT OF ADC

n BIT LATCH

CLOCK

n BITS

n+1 BIT INPUT AND GATE

n EXCLUSIVE OR GATES

CLOCK AT $2^m \cdot 2f_B$

'1'

BITS $P_{m-1}$ TO $P_0$

PRESETABLE DOWN COUNTER (m)BITS

COUNT

m-1 OUTPUT BITS(m)

n+m BIT LATCH

OUTPUT

n+m BITS AT $2f_B$

CLOCK AT $2f_B$

PRESET

CLOCK

Fig-7

CLOCK $2^m \cdot 2f_b$

CLK

n BITS ADC O/P @ $2^m \cdot 2f_b$

$P_{m+n-1}$   $Q_{m+n-1}$

$P_m$   $Q_m$

$P_{m-1}$   $Q_{m-1}$

56

'1'

$P_0$   $Q_0$

PRESET ENABLE

$2f_b$

$D_{m+n-1}$   $Q_{m+n-1}$

$D_0$   $Q_0$

LATCH

58

m+n BITS @ $2f_b$

Fig-8

EP 0 142 907 B1

QUANT BITS = 5
OS FACTOR = 2
REC LNG = 2048
SIN FREQ = 1.0001
iω STEP = 0.50000

Fig. 9

iω(3dB)
iω(3dB/OCT)

Signal to noise ratio (db)

Normalised interpolation waveform amplitude

QUANT BITS = 5
OS FACTOR = 4
REC LNG = 2048
SIN FREQ = 1.0001
iω STEP = 0.25000

Fig. 10

iω(3dB)
iω(3dB/OCT)

Signal to noise ratio (db)

Normalised interpolation waveform amplitude

28

QUANT BITS = 5
OS FACTOR = 8
REC LNG = 2048
SIN FREQ = 1.0001
iω STEP = 0.12500

*Fig. 11*

Signal to noise ratio (db)

$^i\omega$(3dB/OCT)

Normalised interpolation waveform amplitude

QUANT BITS = 5
OS FACTOR = 16
REC LNG = 2048
SIN FREQ = 1.0001
iω STEP = 0.06250

*Fig. 12*

Signal to noise ratio (db)

$^i\omega$(3dB/OCT)

Normalised interpolation waveform amplitude

29

EP 0 142 907 B1

Fig. 13

PERIOD BETWEEN INPUT SAMPLE VALUES

Fig. 14

Fig. 15